# EUROPEAN PATENT APPLICATION

(11) **EP 0 821 026 A1**
(43) Date of publication of application: **28.01.1998**
(21) Application number: 97902595.4
(22) Date of filing: 06.02.1997
(51) Int. Cl.: C08J 7/18, C23C 16/50, C23C 16/54

(54) **CONTINUOUS CVD EQUIPMENT FOR FILMS AND CONTINUOUS CVD PROCESS**

(30) Priority: 07.02.1996 JP 45360/96
(71) Applicant: TOYO METALLIZING CO.,LTD., Tokyo 103 (JP)
(72) Inventor: TOHYAMA, Shunroku Toray Yoroizaka D-54, Shizuoka 411 (JP); MOCHIZUKI, Kiyohito Kopo Hattori 206, Shizuoka 419-01 (JP); YAMASHITA, Masayuki, Shizuoka 410-11 (JP); AOYAGI, Tsutomu, Tokyo 195 (JP)
(74) Representative: Coleiro, Raymond
(86) International application number: JP9700292
(87) International publication number: WO9729149

(57) **Abstract**

The present invention discloses an apparatus and process for continuously processing a film by CVD technique in which a very thin organic compound coating with special functions such as water repellency is formed continuously and stably on a continuously running film.

The present invention provides an apparatus for continuously processing a film by CVD technique, comprising a vacuum vessel, a vacuum pump connected to said vacuum vessel, a vessel which is filled with a compound capable of forming an organic compound coating when plasma-polymerized and can heat the compound for vaporization, a feed roll system for continuously feeding a film into said vacuum vessel, a take-up roll system for taking up the film after chemical vapor deposition, a specific film running region to allow chemical vapor deposition on the surface of the running film continuously fed from the feed roll system and a plasma generation region adjacent to said specific running region, respectively provided between said feed roll system and said take-up roll system, and a piping installation connecting said heatable vessel and the inside of said vacuum vessel, to introduce said compound vaporized in said heatable vessel into the plasma generation region, and also provides a process for continuously processing a film by CVD technique, comprising the step of continuously forming an organic compound coating on a continuously running film by using said apparatus.

## Description

### Technical field

The present invention relates to an apparatus and process for continuously forming an organic compound coating with specific functions, such as water repellency and anti-fouling property on the surface of a film by CVD (chemical vapor deposit) technique.

CVD is well known in this technical field, and is a technique in which a vaporized material is brought into contact with the surface of an object in a plasma atmosphere, to form a coating of the material transformed into a polymer. It is a technique to form a thin film by a dry process and is industrially practically used to some extent.

The present invention relates to a means for continuously forming an organic compound coating with specific functions on a continuously running film by CVD technique, to provide a long film product.

### Prior arts

Japanese Patent Laid-Open (Kokai) Nos. 6-122778 and 6-122776 propose a surface treatment process and apparatus in which a low surface energy material is vaporized and introduced into a reduced pressure treatment chamber containing an object to be treated, and brought into contact with the surface of the object in a plasma atmosphere, for forming a low surface energy coating on the surface of the object.

Furthermore, Japanese Patent Laid-Open (Kokai) No. 6-138305 proposes an optical member with a special structure and composition and treated to be water-repellent, particularly a lens treated to be water-repellent for cameras, spectacles, etc., and presents a conceptual view showing a treatment apparatus for it.

All of the above proposals propose processes in which the object to be treated is a molding such as a lens which is fixed in a vacuum treatment chamber, to have a coating formed on it, and also propose members obtained by the processes.

Japanese Patent Laid-Open (Kokai) 2-248480 proposes a transparent substrate on which a composition containing polyfluoroalkylene groups is formed. The process proposed is a wet coating process comprising the steps of coating a transparent substrate with an organic solvent solution of a silane compound containing a polyfluoroalkylene group, and heating for drying to form a coating. According to the specification, it is intended to use glass or molded plastic sheet as the transparent substrate, and it is not considered at all to continuously form a coating on a continuous long film.

Japanese Patent Laid-Open (Kokai) No. 3-266801 proposes a reflection preventive filter in which an inorganic dielectric film as a reflection preventive film is formed on the surface of a transparent substrate, with a fluorine resin film formed further on it. For the fluorine resin film, a fluorine resin in which the hydrogen atoms in the hydrocarbon main chain skeleton of a polymer such as polytetrafluoroethylene are substituted by fluorine atoms is used, and as a process for forming the film, resistance heating type vacuum deposition is described as an example. However, continuous processing of a film is neither considered nor referred to.

### Disclosure of the invention

Since the processes and apparatuses of the above various prior arts cannot continuously produce a functional film of high quality on a continuous long film by CVD technique at high productivity, the inventors studied to develop a process and apparatus necessary for such continuous production. The object of the present invention is to provide a specific process and apparatus for it. More specifically, the main object of the present invention is to form a thin water-repellent and anti-fouling coating on the reflection preventive film formed on a continuous long plastic film with the reflection preventive film by dry coating only without resorting to any wet coating method of solution coating and drying. Because an optical property of light reflection on the surface is involved and because a very thin coating of tens of angstroms must manifest performance, it is desirable to avoid such a step of drying a coating solution since any slight irregularity of coating or drying is liable to make defects in the product. In this situation, the present invention is intended to realize a continuous process based on CVD technique in which a low molecular compound is introduced as a vapor phase into a reaction system at a reduced pressure close to vacuum and is activated in a plasma condition, to be deposited and formed as a high molecular coating on a film substrate.

The inventors studied intensively, and as a result, the above object of the present invention could be industrially advantageously achieved by the following apparatus and process for continuously processing a film by CVD technique.
[1] An apparatus for continuously processing a film by CVD technique, comprising a vacuum vessel, a vacuum pump connected to said vacuum vessel, a vessel which is filled with a compound capable of forming an organic compound coating when plasma-polymerized and can heat the compound for vaporization, a feed roll system for continuously feeding a film into said vacuum vessel, a take-up roll system for taking up the film after chemical vapor deposition, a specific film running region to allow chemical vapor deposition on the surface of the running film continuously fed from the feed roll system and a plasma generation region adjacent to said specific running region, respectively provided between said feed roll system and said take-up roll system, and a piping installation connecting said heatable vessel and the inside of said vacuum vessel, to introduce said compound vaporized in said heatable vessel into the plasma generation region.
[2] A process for continuously processing a film by CVD technique, comprising the step of continuously forming an organic compound coating on a continuously running film by using the apparatus of the above [1].

In the process for continuously processing a film by CVD technique of the present invention, the organic compound coating is preferably 90° or more in the contact angle with water, and the compound forming the organic compound coating is preferably a reactive silicone compound containing a perfluoro group. Furthermore, in the process for continuously processing a film by CVD technique of the present invention, the film has preferably a multi-layer reflection preventive film formed on one side, and the organic compound coating is continuously formed preferably on the side with the multi-layer reflection preventive film formed.

### Brief description of the drawing

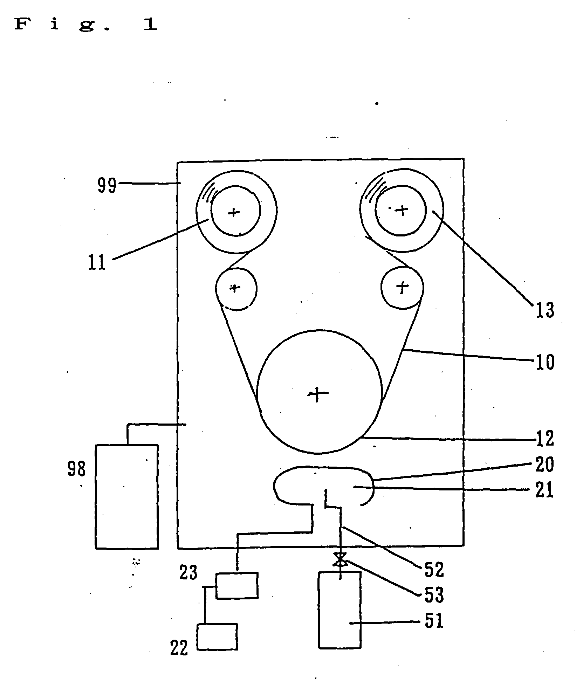

Fig. 1 is a conceptual view showing the apparatus for continuously processing a film by CVD technique of the present invention.

In Fig. 1, the respective symbols denote the following:
- 99: : vacuum vessel
- 98: : vacuum pump system
- 10: : film
- 11: : feed roll
- 12: : specific film running region
- 13: : take-up roll
- 20: : plasma electrode
- 21: : plasma generation region
- 22: : high frequency power source
- 23: : plasma matching box
- 51: : vessel filled with a compound
- 52: : pipe line for introducing the compound into the vacuum vessel
- 53: : valve

### Most preferred embodiments of the invention

The present invention is described below technically in detail.

Fig. 1 shows the constitution of basic components of the equipment for carrying out the process of the present invention, in the sequence of processing.

A vacuum vessel 99 can be adjusted to a required reduced pressure close to vacuum by a vacuum pump system 98. The vacuum pump system 98 is a combination of a plurality of vacuum pumps properly different in pressure reduction capability such as a mechanical pump, molecular drag pump, diffusion pump and cryosorption pump connected in series and/or parallel.

A continuous long film 10 to be processed on the surface is set, being wound around a feed roll 11, and while it is fed through a necessary carrier roll system, to run in a specific running region 12 to allow chemical vapor deposition on one side of the film, an organic compound activated by plasma is deposited on the side to face a plasma generation region 21, to form the intended organic compound coating. Then, the coated film is continuously taken up by a take-up roll 13.

The compound which can be formed as the organic compound coating is put in a heatable vessel 51 installed outside the vacuum vessel 99, and is supplied as a vapor by a heatable pipe line 52 with a valve on its way, to the plasma generation region 21 in the vacuum vessel at a controlled flow rate, being exposed to a plasma condition. The compound is of course selected to achieve the intended functions of the organic compound coating, but since CVD technique is destined to properly manifest the functions by a thickness of tens of angstroms, the compounds available for selection are naturally limited. The compound selected must have a vapor pressure to allow vaporization and deposition to form a coating at a reduced pressure and must be activated in a plasma atmosphere to form a high molecular coating stably on the substrate by reaction. Silane coupling agents based on alkylsilanes or fluoroalkylsilanes with any of various reactive groups such as an epoxy group, amino group, vinyl group or alkoxy group can be preferably used for the compound.

In the present invention, it is one of specific objects to form a thin coating with anti-fouling property such as water repellency and oil repellency on the refection preventive film side of a plastic film with the reflection preventive film. In this case, the performance of water repellency and oil repellency is evaluated in reference to the wettability of the treated surface. Specifically, when the contact angle with water is 90° or more, a substantially clear effect can be manifested.

The thickness of the organic compound coating is controlled by adjusting the heating temperature of the compound supply system, flow rate and film carrying speed.

The plasma condition can be achieved by introducing argon, oxygen or nitrogen, etc. into the vacuum vessel and discharging at a voltage of about 50 to 600 watts using an electrode placed in the vacuum vessel at a pressure of about 10⁻⁴ to 10⁻² torr. The argon, oxygen or nitrogen atoms or molecules are activated, and they activate the compound approaching nearby, to provide reaction activity, thereby causing the compound to react on the surface of the substrate film for forming a high molecular coating.

The above major steps include various apparatuses such as motors for driving the feed roll and the take-up roll and for carrying the film, a drive control system to allow steady carrying at a normal tension, a flow meter for the compound, a pressure gauge for monitoring the vacuum degree, etc., in addition to the above components, though not concretely described.

### Example

The present invention is described below more concretely in reference to an example, but is not limited thereto or thereby since the example is intended to deepen the understanding of the present invention.

On one side of a 188 µm thick 100 m long continuous polyethylene terephthalate film with a 4 µm thick hard coat layer, formed was a reflection preventive film with high reflection preventability of 1% or less in average reflectance in a visible light wavelength range, consisting of the following four layers with the respective layer thicknesses kept as optically designed and calculated.
1st layer: ITO, 2nd layer: SiO₂, 3rd layer: ITO, 4th layer: SiO₂

On the reflection preventive film side of the 100 m long continuous film, an about 40 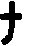 thick coating of a perfluoroalkylsilane condensation product was formed under the following conditions, using the apparatus of Fig. 1. The contact angle with water was 107°.

The CVD processing conditions were as follows:
- Compound:: (Heptadecafluoro-1,1,2,2-tetrahydrodecyl)-1-1-trimethoxysilane
- Pressure reduction:: The vacuum vessel was once reduced in pressure to 4 x 10⁻⁵ torr, and the compound was introduced. While CVD coating was formed, a pressure of 7 x 10⁻⁴ torr was kept in a steady state.
- Discharge voltage:: 100 W high frequency power (frequency 13.56 MHz)
- Vapor deposition time:: 12 seconds (calculated from the film carrying speed and the exposed length)
- Heating temperature:: 85°C (vessel temperature and pipeline temperature)

### Industrial applicability

The present invention allows a very thin organic compound coating with special functions such as water repellency to be industrially stably formed on a continuously running film by CVD technique, and allows a thin film with anti-fouling property such as water repellency and oil repellency to be industrially stably and continuously formed on the reflection preventive film side of a plastic film with the reflection preventive film. The reflection preventive plastic film with anti-fouling property such as water repellency and oil repellency can be used as an optical article to be mounted on the front of a liquid crystal display (LCD), cathode ray tube (CRT) of a television set or computer, or any other display screen.

## Claims

1. An apparatus for continuously processing a film by CVD technique, comprising a vacuum vessel, a vacuum pump connected to said vacuum vessel, a vessel which is filled with a compound capable of forming an organic compound coating when plasma-polymerized and can heat the compound for vaporization, a feed roll system for continuously feeding a film into said vacuum vessel, a take-up roll system for taking up the film after chemical vapor deposition, a specific film running region to allow chemical vapor deposition on the surface of the running film continuously fed from the feed roll system and a plasma generation region adjacent to said specific running region, respectively provided between said feed roll system and said take-up roll system, and a piping installation connecting said heatable vessel and the inside of said vacuum vessel, to introduce said compound vaporized in said heatable vessel into the plasma generation region.

2. A process for continuously processing a film by CVD technique, comprising the step of continuously forming an organic compound coating on a continuously running film by using the apparatus of claim 1.

3. A process for continuously processing a film by CVD technique, according to claim 2, wherein the organic compound coating is 90° or more in the contact angle with water.

4. A process for continuously processing a film by CVD technique, according to claim 2 or 3, wherein the compound forming the organic compound coating is a reactive silicone compound with a perfluoro group.

5. A process for continuously processing a film by CVD technique, according to any one of claims 2 through 4, wherein the film has a multi-layer reflection preventive film on one side, and the organic compound coating is continuously formed on the side with the multi-layer reflection preventive film formed.
